# EUROPÄISCHE PATENTSCHRIFT

(11) **EP 2 041 809 B1**
(45) Veröffentlichungstag und Bekanntmachung des Hinweises auf die Patenterteilung: **28.07.2010**
(21) Anmeldenummer: 07765544.7
(22) Anmeldetag: 21.06.2007
(51) Int. Cl.: H01L 39/16, H02H 9/02

(54) **RESISTIVE SUPRALEITENDE STROMBEGRENZEREINRICHTUNG MIT BIFILARER SPULENWICKLUNG AUS HTS-BANDLEITERN UND WINDUNGSABSTANDSHALTER**
RESISTIVE SUPERCONDUCTIVE CURRENT LIMITER DEVICE HAVING BIFILAR WINDING MADE OF HTS STRIP CONDUCTORS AND WINDING SPACER
DISPOSITIF SUPRACONDUCTEUR RÉSISTIF LIMITEUR DE COURANT AVEC BOBINAGE BIFILAIRE EN CONDUCTEURS PLATS HTS ET ÉCARTEUR DE SPIRE

(30) Priorität: 14.07.2006 DE 102006032702
(43) Veröffentlichungstag der Anmeldung: 01.04.2009
(73) Patentinhaber: SIEMENS AKTIENGESELLSCHAFT, 80333 München (DE)
(72) Erfinder: KRÄMER, Hans-Peter, 91058 Erlangen (DE); SCHMIDT, Wolfgang, 91056 Erlangen (DE)
(86) Internationale Anmeldenummer: PCT/EP2007/056204
(87) Internationale Veröffentlichungsnummer: WO 2008/006689

(56) Entgegenhaltungen:
- EP-A- 0 503 448
- WO-A-2004/006345
- WO-A-2006/037741

## Beschreibung

Die Erfindung bezieht sich auf eine supraleitende Strombegrenzereinrichtung vom resistiven Typ mit wenigstens einer bifilaren Spulenwicklung aus mindestens einem bandförmigen HTS-Leiter, wobei zwischen benachbarten Windungen der Spulenwicklung wenigstens ein elektrisch isolierender Abstandshalter angeordnet ist, der für ein Kältemittel zumindest in Teilbereichen transparent ist. Eine solche resistive Strombegrenzereinrichtung geht aus der DE 10 2004 048 646 A1 hervor.

Seit Bekannt-Werden von supraleitenden Metalloxidverbindungen mit hohen Sprungtemperaturen T_{c} von über 77 K, die deshalb auch als Hoch-T_{c}-Supraleitermaterialien oder HTS-Materialien bezeichnet werden und insbesondere eine Flüssig-Stickstoff (LN₂)-Kühlung erlauben, ist man versucht, mit entsprechenden HTS-Leitern auch supraleitende Strombegrenzereinrichtungen zu konzipieren. Eine solche Strombegrenzereinrichtung ist der vorgenannten DE-A1-Schrift zu entnehmen. Sie ist mit mindestens einem bandförmigen HTS-Leiter aufgebaut, der ein metallisches, texturiertes Trägerband, insbesondere ein sogenanntes RABiTS-Band aus einer Ni-Legierung, aufweist (vgl. "Applied Superconductivity", Vol.4, Nos.10-11, 1996, Seiten 403 bis 427). Auf diesem Trägerband ist ein Schichtensystem aus oxidischen Puffermaterialien, wie beispielsweise CeO₂ oder Y₂O₃, und dem HTS-Material, insbesondere aus YBa₂Cu₃Oₓ (sogenanntes "YBCO") , abgeschieden. Dieser Aufbau ist noch von einer dünnen normalleitenden Deckschicht überzogen, um sogenannte "Hot-Spots" zu unterdrücken (vgl. auch DE 198 36 860 A1), wobei zusätzlich noch Maßnahmen zur Vermeidung von elektrischen Überschlägen zwischen der Deckschicht und dem metallischen Substratband getroffen sind. Ein entsprechender Leitertyp wird auch als "Coated Conductor" bezeichnet. Aus einem solchen HTS-Bandleiter ist bei der bekannten Strombegrenzereinrichtung eine spiralförmige bifilare Spulenwicklung mit guter Zugänglichkeit für das Kältemittel LN₂ gewickelt. Hierzu ist mit dem HTS-Bandleiter noch ein bandförmiger Abstandshalter aus einem isolierenden Material mit eingewickelt, der zugleich eine hinreichende gegenseitige Isolation benachbarter Spulenwindungen gewährleistet.

WO99/33122 offenbart eine supraleitende Strombegrenzereinrichtung vom resistiven Typ, welche eine supraleitende Leiterbahn aufweist. Die supraleitende Leiterbahn wird als bifilarer Scheibenwickel ausgebildet, wobei sich zwischen benachbarten Bandlagen des Wickels Isolierbänder zur elektrischen Isolation befinden. Derartige Isolierbänder können beispielsweise eine gewellte oder gerippte Struktur aufweisen.

EP 0 444 792 A2 offenbart eine supraleitende Spule aus einem Dünnschichtsupraleiter (coated conductor). Der Dünnschichtsupraleiter kann zu einer sogenannten Pancake-Spule geformt werden. Benachbarte Windungen können dabei durch stegartige Abstandselemente untereinander beabstandet sein, die wirksam untereinander in Ausdehnungsrichtung eines Trägerbandes beabstandet sind.

Für die Wirtschaftlichkeit von entsprechenden Strombegrenzereinrichtungen sind die benötigte Materialmenge an HTS-Bandleiter und die spezifischen Kosten entscheidend. Die Materialmenge wird ihrerseits durch die Parameter "Kritischer Strom pro Breite des (I_{c}/w)" und "Zulässiger Spannungsabfall pro Länge des Bandes (U/L)" bestimmt. Beide Parameter sollten möglichst groß sein. Während die Größe I_{c}/w einzig durch die Eigenschaften und das Herstellungsverfahren der Supraleiterschicht bestimmt wird, hängt die Größe U/L von den Eigenschaften der nicht-supraleitenden Teile des Schichtaufbaus ab, d.h. insbesondere vom Substratband und der Deckschicht. Bei vorgegebener Abschaltzeit und Endtemperatur der Strombegrenzerspulenwicklung während einer Begrenzungsphase ist (U/L)² durch das Produkt aus "Flächenwiderstand" (sogenannte "Sheet resistance") und flächenbezogener Wärmekapazität bestimmt, wobei über alle Schichten des Leiteraufbaus summiert wird. Beispielsweise ist für einen RABiTS-Bandleiter mit Ni-Legierungssubstratband, dessen thermische Masse im Wesentlichen vom Substratband gebildet wird, bei 50 ms Abschaltzeit und 300 K Endtemperatur die Größe U/L = 0,4 V/cm. Bei einem anderen bekannten Typ einer Strombegrenzereinrichtung, bei der eine HTS-Leiterbahn auf einer ausgedehnten Substratplatte aus Saphir ausgebildet ist und eine Au-Deckschicht aufweist, liegt hingegen U/L im Bereich von 9 bis 10 V/cm. Ursache für diesen deutlich höheren Wert eines solchen "Saphirplattenleiters" ist das Substrat, das eine große Wärmekapazität zur Verfügung stellt, gleichzeitig aber als Isolator praktisch keine Joule'sche Wärme erzeugt.

Aufgabe der vorliegenden Erfindung ist es, die Strombegrenzereinrichtung mit den eingangs genannten Merkmalen dahingehend auszubilden, dass sie gegenüber bekannten Strombegrenzereinrichtungen vom gleichen Typ unter Verwendung von HTS-Bandleitern ("Coated Conductors") eine verbesserte Wärmeabfuhr und eine größere zulässige Spannung pro Leiterlänge aufweist.

Diese Aufgabe wird mit den in Anspruch 1 angegebenen Maßnahmen gelöst. Demgemäß soll die Strombegrenzereinrichtung mit den eingangs genannten Merkmalen dahingehend ausgestaltet sein, dass ihr Abstandshalter ein bandförmiges Trägerband aus elektrisch isolierendem Material aufweist, welches auf wenigstens einer seiner Flachseiten mit Abstandselementen aus elektrisch isolierendem Material versehen ist, die untereinander in Ausdehnungsrichtung des Trägerbandes beabstandet sind und aus einem Material mit hoher thermischer Leitfähigkeit bestehen. Unter einer hohen thermischen Leitfähigkeit wird in diesem Zusammenhang ein Wert λ von mindestens 10 W/m·K verstanden.

Die mit dieser Ausgestaltung der Strombegrenzereinrichtung verbundenen Vorteile sind insbesondere darin zu sehen, dass ihr Abstandshalter neben einer elektrisch isolierenden Funktion auch als eine sogenannte "Wärmesenke" wirkt. Diese Wärmesenke lässt sich dabei so ausführen, dass bei üblichen spezifischen Wärmen von Isolierstoffen die Größe U/L gegenüber einem "blanken" Bandleiter (ohne Abstandshalter) deutlich (d.h. um mindestens einen Faktor 2) erhöht wird. Dies ist insbesondere auch durch eine hinreichende Dicke (in Abstandsrichtung zwischen den Windungen gemessen) von insbesondere mehr als 0,5 mm zu erreichen. Die Wärmesenke schränkt dabei vorteilhaft die Herstellung entsprechender Spulenwicklungen aus dem HTS-Bandleiter nicht ein, da sie hierfür hinreichend biegsam ausgestaltet sein kann. Außerdem ist ihre Wärmeleitfähigkeit so groß einzustellen, dass die in den metallischen Komponenten des HTS-Bandleiters erzeugte Joule'sche Wärme während der Begrenzungszeit der Strombegrenzer genügend tief eindringen kann, d.h., dass eine hohe thermische Diffusionskonstante gegeben ist, und dass damit eine hohe Wärmekapazität pro Leiterfläche bereitgestellt wird. Außerdem ist auch der thermische Übergangswiderstand zwischen dem metallischen HTS-Bandleiter und der elektrisch isolierenden Wärmesenke hinreichend klein zu halten. Schließlich verlängert die Wärmesenke die Rückkühlzeit nach einer Begrenzungsphase nur in geringem Maße. Da nämlich die Rückkühlzeit im Wesentlichen durch das Verhältnis aus gespeicherter Energie und der für eine Wärmeabfuhr zur Verfügung stehenden Oberfläche bestimmt wird, lässt sich durch die Ausgestaltung des Abstandshalter die für eine Rückkühlung verfügbare Grenzfläche zum Kältemittel analog zur erhöhten Wärmekapazität vergrößern.

Vorteilhafte Ausgestaltungen der erfindungsgemäßen supraleitenden Strombegrenzereinrichtung gehen aus den von Anspruch 1 abhängigen Ansprüchen hervor. Dabei kann die Ausführungsform nach diesem Anspruch mit den Merkmalen eines der Unteransprüche oder vorzugsweise auch denen aus mehreren Unteransprüchen kombiniert werden. Demgemäß kann die Strombegrenzereinrichtung nach der Erfindung zusätzlich noch folgende Merkmale aufweisen:
- So können vorteilhaft die Abstandselemente stegartig ausgebildet sein. Solche Abstandselemente lassen sich im Hinblick auf eine gute Wärmeabfuhr hinreichend massiv ausführen, wobei ihr gegenseitiger Abstand auch für eine gute Kältemitteltransparenz zu wählen ist. Die erforderliche Flexibilität des Trägerbandes wird dabei praktisch nicht eingeschränkt.
- Die Abstandselemente werden bevorzugt aus einem keramischen Material gebildet. Insbesondere mit Al₂O₃ oder AlN lässt sich die Forderung nach hoher Wärmeleitfähigkeit gut erfüllen.
- Die Abstandselemente sind auf dem Trägerband einseitig oder auch beidseitig auf dessen Flachseite(n) zu befestigen, so dass sie dann zusammen mit dem Trägerband ein gemeinsames, vorzufertigendes Bauteil bilden. Damit wird ein universeller Einsatz des Abstandshalters ermöglicht.
- Die Befestigung der Abstandselemente auf dem Trägerband kann dabei vorteilhaft durch ein Verkleben erfolgen.
- Bevorzugt besteht das Trägerband aus einem Kunststoffmaterial. Entsprechende Trägerbänder sind einerseits hinreichend flexibel und gewährleisten andererseits eine gute elektrische Windungsisolation.
- Zusätzlich können die Abstandselemente mit dem jeweils anliegenden Teil des HTS-Leiters mechanisch verbunden sein. Mit einer entsprechenden Verbindung ist ein guter Wärmeübergang zwischen diesen Teilen zu erreichen.
- Hierzu lassen sich die Abstandselemente mit dem jeweiligen HTS-Leiterteil verkleben oder auch nach einer Vorbelotung der entsprechenden Bereiche verlöten.

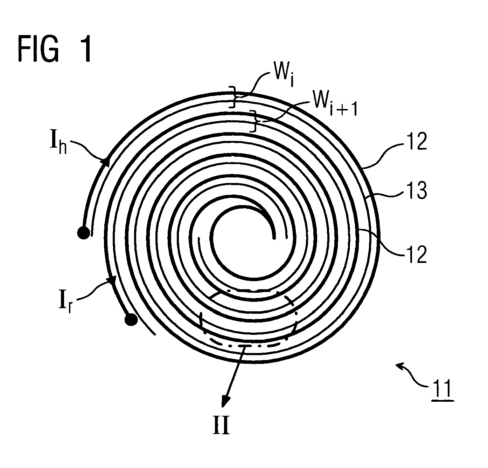

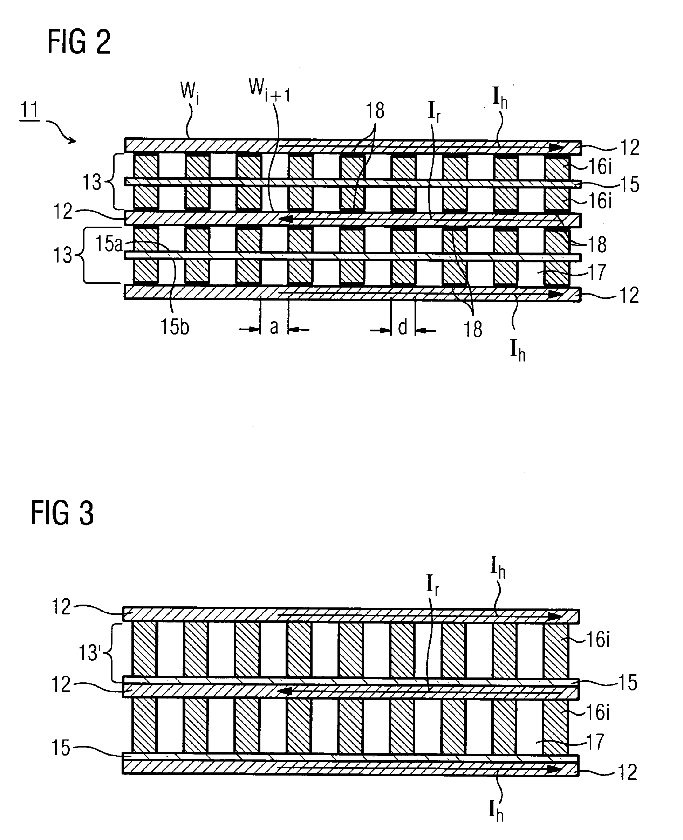

Weitere vorteilhafte Ausgestaltungen der erfindungsgemäßen Strombegrenzereinrichtung gehen aus den vorstehend nicht angesprochenen Ansprüchen sowie insbesondere aus der nachfolgend erläuterten Zeichnung hervor, in der bevorzugte Ausgestaltungen der erfindungsgemäßen Strombegrenzereinrichtung angedeutet sind. Dabei zeigen jeweils in stark schematisierter Darstellung
- deren Figur 1 den prinzipiellen Aufbau einer bifilaren Spulenwicklung der Strombegrenzereinrichtung in Aufsicht,
- deren Figur 2 als Ausschnitt aus der Spulenwicklung nach Figur 1 eine erste Ausbildungsmöglichkeit des Wicklungsaufbaus im Querschnitt
und
- deren Figur 3 eine weitere Ausbildungsmöglichkeit des Wicklungsaufbaus in Figur 2 entsprechender Darstellung. Dabei sind in den Figuren sich entsprechende Teile jeweils mit denselben Bezugszeichen versehen.

In Figur 1 sind die wesentlichen Teile eines Aufbaus einer allgemein mit 11 bezeichneten Spulenwicklung einer erfindungsgemäßen Strombegrenzereinrichtung veranschaulicht. Bei diesem Aufbau wird von an sich bekannten Ausführungsformen bifilarer Spulenwicklungen entsprechender Einrichtungen ausgegangen, wie sie z.B. der genannten DE 10 2004 048 646 A1 zu entnehmen sind. Die Spulenwicklung ist mit mindestens einem bandförmigen HTS-Leiter 12 wie insbesondere einem YBCO(YBa₂Cu₃Oₓ)-Bandleiter vom "Coated Conductor"-Typ als flache, scheibenförmige Wicklung erstellt. Entsprechende Bandleiter weisen auf einem Substrat insbesondere aus einem Metall eine YBCO-Schicht mit mindestens einer dazwischenliegenden Pufferschicht auf, wobei die YBCO-Schicht von einer normalleitenden Deckschicht abgedeckt ist (vgl. z.B. die genannte DE-A1-Schrift). Bei der Erstellung der Spulenwicklung 11 ist zusammen mit dem YBCO-Bandleiter 12 ein für ein Kältemittel zumindest in Teilbereichen transparenter Abstandshalter 13 mit eingewickelt, der hierfür eine hinreichende Flexibilität aufweist sowie für eine Beabstandung benachbarter Windungen Wᵢ, Wᵢ₊₁ und für die erforderliche Kältemitteltransparenz sorgt. Da der Abstandshalter 13 zumindest teilweise aus isolierendem Material besteht, ist auch die erforderliche elektrische Isolation zwischen den Windungen gewährleistet. In der Figur sind ferner auch die Stromflussrichtungen eines zu schaltenden bzw. zu begrenzenden Stromes I in Hinrichtung mit Iₕ und in Rückrichtung mit Iᵣ bezeichnet und durch Pfeile angedeutet.

Eine erfindungsgemäße Ausgestaltung des Abstandshalters 13 geht aus Figur 2 hervor, die einen Ausschnitt aus der flachen Spulenwicklung 11 nach Figur 1 wiedergibt. Die gezeigte Ausführungsform des Abstandshalters 13 umfasst dabei ein flexibles, elektrisch isolierendes Trägerband 15 beispielsweise aus einer handelsüblichen Isolierfolie, deren Breite an die des HTS-Bandleiters 12 angepasst ist und vorzugsweise annähernd gleich ist.

Weiterhin kann das elektrisch isolierende Trägerband 15 breiter als der HTS-Bandleiter 12 ausgeführt sein, um insbesondere Anforderungen hinsichtlich einer verbesserten Spannungsfestigkeit zu genügen.

An den beiden Flachseiten 15a und 15b dieses Trägerbandes 15 sind in Längsrichtung bzw. in HTS-Leiterausdehnungsrichtung hintereinander stegartige Abstandselemente 16i befestigt. Beispielsweise können diese Abstandselemente auf das Trägerband 15 aufgeklebt werden. Sie bilden vorteilhaft mit dem Trägerband 15 ein vorzufertigendes, für den Wicklungsaufbau hinreichend flexibles Bauteil. Die sich quer zur Längsrichtung erstreckenden Abstandselemente 16i weisen eine vorgegebene Dicke d und einen vorgegebenen gegenseitigen Abstand a auf. Ihre Breite entspricht zumindest annähernd der des Trägerbandes 15 und/oder der des HTS-Bandleiters 12 in der jeweils benachbarten Spulenwindung. Ebenfalls vorteilhaft kann die Breite des Trägerbandes 15 größer als die Breite des HTS-Bandleiters 12 sein, insbesondere kann die Breite des Trägerbandes 15 im Wesentlichen den doppelten Wert wie die Breite des HTS-Bandleiters 12 annehmen.

Die Dicke d und der Abstand a werden vorteilhaft so gewählt, dass die Abstandselemente 16i eine für eine Schaltfunktion und eine Hot-Spots-Unterdrückung hinreichend passive Wärmesenke darstellen können. Wählt man insbesondere für die Abstandselemente 16i eine Keramik mit hoher Wärmeleitfähigkeit, beispielsweise Al₂O₃ oder AlN, dann können d und a zumindest annähernd in der gleichen Größenordnung von beispielsweise 1 mm bis 5 mm liegen. D.h., die Abstandselemente 16i können in Längsrichtung des Bandleiters um einen Abstand a zwischen 1 mm und 5 mm beabstandet sein. Ihre in dieser Richtung zumessende Dicke d kann dabei zwischen 1 mm und 5 mm liegen. Die Wärmeleitfähigkeit λ der genannten Keramiken liegt dabei in einem Bereich von etwa 10 W/mK bis 60 W/mK (bei 20°C), so z.B. für Al₂O₃ bei 45 W/mK.

Der so als ein "Stegband" anzusehende Abstandshalter 13 lässt sich auf Grund seiner hinreichenden Flexibilität zusammen mit dem HTS-Bandleiter 12 in bekannter Weise zu der bifilaren Flachspulenwicklung 11 wickeln. Dabei wirkt zumindest das Trägerband 15 zugleich auch als elektrische Isolation zwischen den einzelnen Windungen Wᵢ, Wᵢ₊₁ der Spulenwicklung. Die verbleibenden, Kühlkanäle 17 bildenden Zwischenräume zwischen den stegartigen Abstandselementen 16i, und gestatten eine gute Transparenz für ein Kältemittel wie LN₂. Vorteilhaft ist dabei, dass der als Wärmesenke wirkende Abstandshalter 13 und der HTS-Bandleiter 12 zunächst voneinander getrennt sind, d.h. auch in getrennten Arbeitsschritten vorgefertigt werden können, bzw. bei verschiedenen Herstellern bezogen werden können. Der Hersteller des HTS-Bandleiters 12 kann so seinen Standardprozess unverändert beibehalten.

Selbstverständlich sind auch andere Ausführungsformen für die Abstandselemente 16i einsetzbar, sofern mit ihnen eine hinreichend große "thermische Masse" bzw. Wärmeleitfähigkeit einer Wärmesenke bereitzustellen ist, mit der die genannten Funktionen zu erfüllen sind. So können verschiedene Größen für den Abstand a und/oder die Dicke d sowie andere Formen für die Abstandselemente vorgesehen werden.

Besonders vorteilhaft wird für einen guten Wärmeübergang zwischen dem HTS-Bandleiter 12 und dem Abstandshalter 13 mit seinen Abstandselementen 16i gesorgt. Zur Erzeugung eines entsprechenden "Festkörperkontaktes" zwischen diesen Teilen kann man z.B. die Flachspulenwicklung nach dem Wickelvorgang mit einem dünnflüssigen Imprägnierharz tränken, das auch in die engen Spalte zwischen dem HTS-Bandleiter 12 und den benachbarten Abstandselementen 16i eindringt, jedoch aus dem Bereich zwischen den Abstandselementen 16i wieder heraus fließt und somit die erwünschten Kühlkanäle 17 zwischen den Abstandselementen 16i wieder freigibt bzw. offen lässt.

Selbstverständlich sind auch andere Techniken zu einer entsprechenden thermischen Kontaktierung der Abstandselemente 16i mit dem HTS-Bandleiter 12 möglich. So kann man beispielsweise die den HTS-Bandleiter 12 berührenden Seiten der beispielsweise keramischen Abstandselemente 16i metallisieren und mit einer Lotschicht versehen. Die fertig gestellte Spulenwicklung wird hiernach auf die Schmelztemperatur des Lotes erwärmt, so dass sich dieses mit der metallischen, gegebenenfalls ebenfalls vorbeloteten Oberfläche des HTS-Bandleiters 12bzw. seiner normalleitenden Deckschicht verbindet. In den Figuren sind entsprechende Lötstellen (oder Klebestellen gemäß der alternativen Verbindungstechnik) zwischen den Abstandselementen 16i und dem HTS-Bandleiter nur angedeutet und mit 18 bezeichnet.

Der vorstehend beschriebene Aufbau ermöglicht eine ausreichende, bezüglich der Spulenwicklung radial Ausdehnung bzw. Dicke der Abstandselemente 16i und damit des gesamten Abstandshalters 13. Diese Ausdehnung bzw. Dicke kann vorteilhaft größer als die thermische Diffusionstiefe sein. Diese thermische Diffusionstiefe beträgt z.B. bei stegartigen Al₂O₃-Abstandselementen 16i, bei einer Temperatur von 300 K und einem üblichen Wert für die Schaltzeit von 50 ms, etwa 0,8 mm. Zugleich ist eine große Rückkühlfläche mit den den Kühlkanälen 17 zugewandten Seitenflächen der Abstandselemente 16i zu gewährleisten.

Auch in Figur 2 sind die antiparallelen Stromflussrichtungen Iₕ und Iᵣ in benachbarten Spulenwindungen Wᵢ, Wᵢ₊₁ aufgrund des bifilaren Aufbaus der Spulenwicklung durch Pfeile an dem HTS-Bandleiter 12 veranschaulicht.

Bei der in Figur 2 gezeigten Ausführungsform von Abstandshaltern 13 wurde davon ausgegangen, dass dessen Abstandselemente 16i beidseitig an einem Trägerband 15 angebracht sind. Figur 3 zeigt davon abweichend eine Ausführungsform eines Abstandshalters 13' mit einseitiger Anordnung der Abstandselemente 16i an einem Trägerband 15.

## Patentansprüche

1. Supraleitende Strombegrenzereinrichtung vom resistiven Typ mit wenigstens einer bifilaren Spulenwicklung (11) aus mindestens einem bandförmigen HTS-Leiter (12), wobei zwischen benachbarten Windungen (Wᵢ, Wᵢ₊₁) der Spulenwicklung wenigstens ein elektrisch isolierender Abstandshalter (13, 13') angeordnet ist, der für ein Kältemittel zumindest in Teilbereichen transparent ist, **dadurch gekennzeichnet, dass** der Abstandshalter (13, 13') ein bandförmiges Trägerband aus elektrisch isolierendem Material aufweist, welches auf wenigstens einer seiner Flachseiten (15a, 15b) mit Abstandselementen (16i) aus elektrisch isolierendem Material versehen ist, die untereinander in Ausdehnungsrichtung des Trägerbandes (15) beabstandet sind und aus einem Material mit hoher thermischer Leitfähigkeit bestehen.

2. Strombegrenzereinrichtung nach Anspruch 1, **gekennzeichnet durch** Abstandselemente (16i) mit einer thermischen Leitfähigkeit bei 20°C zwischen 10 und 200 W/mK.

3. Strombegrenzereinrichtung nach Anspruch 1 oder 2, **dadurch gekennzeichnet, dass** die Abstandselemente (16i) stegartig ausgebildet sind.

4. Strombegrenzereinrichtung nach einem der vorangehenden Ansprüche, **dadurch gekennzeichnet, dass** die Abstandselemente (16i) aus einem keramischen Material gebildet sind.

5. Strombegrenzereinrichtung nach Anspruch 4, **dadurch gekennzeichnet, dass** als keramisches Material Al₂O₃ oder AlN vorgesehen ist.

6. Strombegrenzereinrichtung nach einem der vorangehenden Ansprüche, **dadurch gekennzeichnet, dass** die Abstandselemente (16i) auf dem Trägerband (15) befestigt sind.

7. Strombegrenzereinrichtung nach Anspruch 6, **dadurch gekennzeichnet, dass** die Abstandselemente (16i) mit dem Trägerband (15) verklebt sind.

8. Strombegrenzereinrichtung nach einem der vorangehenden Ansprüche, **dadurch gekennzeichnet, dass** das Trägerband (15) aus einem Kunststoffmaterial besteht.

9. Strombegrenzereinrichtung nach einem der vorangehenden Ansprüche, **dadurch gekennzeichnet, dass** die Abstandselemente (16i) und das Trägerband (15) ein gemeinsames, vorzufertigendes Bauteil bilden.

10. Strombegrenzereinrichtung nach einem der vorangehenden Ansprüche, **dadurch gekennzeichnet, dass** die Abstandselemente (16i) in Längsrichtung um einen Abstand (a) zwischen 1 mm und 5 mm beabstandet sind.

11. Strombegrenzereinrichtung nach einem der vorangehenden Ansprüche, **dadurch gekennzeichnet, dass** die Abstandselemente in Längsrichtung eine Dicke (d) zwischen 1 mm und 5 mm aufweisen.

12. Strombegrenzereinrichtung nach einem der vorangehenden Ansprüche, **dadurch gekennzeichnet, dass** das Trägerband (15) und/oder die Abstandselemente (16i) eine Breite aufweist/ aufweisen, die mindestens zumindest annähernd der des HTS-Bandleiters (12) entspricht.

13. Strombegrenzereinrichtung nach einem der Ansprüche 1 bis 11, **dadurch gekennzeichnet, dass** das Trägerband (15) und/oder die Abstandselemente (16i) eine Breite aufweist/aufweisen, die zumindest annähernd der doppelten Breite des Bandleiters (12) entspricht.

14. Strombegrenzereinrichtung nach einem der vorangehenden Ansprüche, **dadurch gekennzeichnet, dass** die Abstandselemente (16i) mit dem jeweils anliegenden Teil des HTS-Bandleiters (12) mechanisch verbunden sind.

15. Strombegrenzereinrichtung nach Anspruch 14, **dadurch gekennzeichnet, dass** die Abstandselemente (16i) mit dem jeweiligen HTS-Bandleiterteil verklebt oder verlötet sind.

## Claims

1. Superconducting current-limiter device of the resistive type having at least one bifilar coil winding (11) composed of at least one HTS conductor (12) in the form of a ribbon, with at least one electrically insulating spacer (13, 13') being arranged between adjacent turns (Wᵢ, Wᵢ₊₁) of the coil winding, which spacer (13, 13') is transparent for a coolant, at least in subareas, **characterized in that** the spacer (13, 13') has a support ribbon, which is in the form of a ribbon, is composed of electrically insulating material and is provided on at least one of its flat faces (15a, 15b) with spacing elements (16i) composed of electrically insulating material, which are separated from one another in the extent direction of the support ribbon (15) and are composed of a material with high thermal conductivity.

2. Current-limiter device according to Claim 1, **characterized by** spacing elements (16i) having a thermal conductivity at 20°C of between 10 and 200 W/mK.

3. Current-limiter device according to Claim 1 or 2, **characterized in that** the spacing elements (16i) are in the form of webs.

4. Current-limiter device according to one of the preceding claims, **characterized in that** the spacing elements (16i) are formed from a ceramic material.

5. Current-limiter device according to Claim 4, **characterized in that** Al₂O₃ or AlN is provided as the ceramic material.

6. Current-limiter device according to one of the preceding claims, **characterized in that** the spacing elements (16i) are mounted on the support ribbon (15).

7. Current-limiter device according to Claim 6, **characterized in that** the spacing elements (16i) are adhesively bonded to the support ribbon (15).

8. Current-limiter device according to one of the preceding claims, **characterized in that** the support ribbon (15) is composed of a plastic material.

9. Current-limiter device according to one of the preceding claims, **characterized in that** the spacing elements (16i) and the support ribbon (15) form a common component which can be prefabricated.

10. Current-limiter device according to one of the preceding claims, **characterized in that** the spacing elements (16i) are separated in the longitudinal direction by a distance (a) of between 1 mm and 5 mm.

11. Current-limiter device according to one of the preceding claims, **characterized in that** the spacing elements have a thickness (d) in the longitudinal direction of between 1 mm and 5 mm.

12. Current-limiter device according to one of the preceding claims, **characterized in that** the support ribbon (15) and/or the spacing elements (16i) has/have a width which corresponds at least approximately to that of the HTS ribbon conductor (12).

13. Current-limiter device according to one of Claims 1 to 11, **characterized in that** the support ribbon (15) and/or the spacing elements (16i) has/have a width which corresponds at least approximately to twice the width of the ribbon conductor (12).

14. Current-limiter device according to one of the preceding claims, **characterized in that** the spacing elements (16i) are mechanically connected to that part of the HTS ribbon conductor (12) which in each case rests on them.

15. Current-limiter device according to Claim 14, **characterized in that** the spacing elements (16i) are adhesively bonded or soldered to the respective HTS ribbon conductor part.

## Revendications

1. Dispositif supraconducteur limiteur de courant du type résistif, comprenant au moins un enroulement ( 11 ) de bobine bifilaire constitué d'au moins un conducteur ( 12 ) HTS en ruban, au moins une entretoise ( 13, 13' ) isolante du point de vue électrique étant disposée entre des spires ( Wi, Wi+1 ) voisines de l'enroulement de bobine, l'entretoise étant transparente pour un fluide frigorigène au moins dans des zones partielles, **caractérisé en ce que** l'entretoise ( 13, 13' ) comporte un ruban support en forme de ruban en matériau isolant du point de vue électrique, qui est muni sur au moins l'une des ses faces ( 15a, 15b ) plates d'éléments ( 16i ) d'espacement en matière isolante du point de vue électrique, qui sont à distance des uns des autres dans la direction dans laquelle s'étend le ruban ( 15 ) support et qui sont en un matériau ayant une grande conductibilité thermique.

2. Dispositif limiteur de courant suivant la revendication 1, **caractérisé par** des éléments ( 16i ) d'espacement, ayant une conductibilité thermique à 20°C comprise entre 10 et 200 W/mK.

3. Dispositif limiteur de courant suivant la revendication 1 ou 2, **caractérisé en ce que** les éléments ( 16i ) d'espacement sont constitués sous la forme de barrette.

4. Dispositif limiteur de courant suivant l'une des revendications précédentes, **caractérisé en ce que** les éléments ( 16i ) d'espacement sont en un matériau céramique.

5. Dispositif limiteur de courant suivant la revendication 4, **caractérisé en ce qu'**il est prévu A1203 ou AlN comme matériau céramique.

6. Dispositif limiteur de courant suivant l'une des revendications précédentes, **caractérisé en ce que** les éléments ( 16i ) d'espacement sont fixés sur le ruban ( 15 ) support.

7. Dispositif limiteur de courant suivant la revendication 6, **caractérisé en ce que** les éléments ( 16i ) d'espacement sont collés sur le ruban ( 15 ) support.

8. Dispositif limiteur de courant suivant l'une des revendications précédentes, **caractérisé en ce que** le ruban ( 15 ) support est en une matière plastique.

9. Dispositif limiteur de courant suivant l'une des revendications précédentes, **caractérisé en ce que** les éléments ( 16i ) d'espacement et le ruban ( 15 ) support forment un élément commun préfabriqué.

10. Dispositif limiteur de courant suivant l'une des revendications précédentes, **caractérisé en ce que** les éléments ( 16i ) d'espacement sont distant d'une distance ( a ) comprise entre 1 mm et 5 mm dans la direction longitudinale.

11. Dispositif limiteur de courant suivant l'une des revendications précédentes, **caractérisé en ce que** les éléments d'espacement ont dans la direction longitudinale une épaisseur ( d ) comprise entre 1 mm et 5 mm.

12. Dispositif limiteur de courant suivant l'une des revendications précédentes, **caractérisé en ce que** le ruban ( 15 ) support et/ou les éléments ( 16i ) d'espacement a/ont une largeur qui correspond au moins à peu près à celle du conducteur ( 12 ) en ruban HTS.

13. Dispositif limiteur de courant suivant l'une des revendications 1 à 11, **caractérisé en ce que** le ruban ( 15 ) support et/ou les éléments ( 16i ) d'espacement a/ont une largeur qui correspond au moins à peu près à deux fois la largeur du conducteur ( 12 ) en ruban.

14. Dispositif limiteur de courant suivant l'une des revendications précédentes, **caractérisé en ce que** les éléments ( 16i ) d'espacement sont assemblés mécaniquement à la partie respective du conducteur ( 12 ) en ruban HTS, à laquelle il s'applique.

15. Dispositif limiteur de courant suivant la revendication 14, **caractérisé en ce que** les éléments ( 16i ) d'espacement sont collés ou brasés à la partie de conducteur en ruban HTS respective.
